Europäisches Patentamt

European Patent Office

Office européen des brevets

(19)

(11) Publication number: **0 078 687**
**B1**

(12) **EUROPEAN PATENT SPECIFICATION**

(45) Date of publication of patent specification: **14.10.87**

(51) Int. Cl.⁴: **H 03 M 1/00**

(21) Application number: **82305778.1**

(22) Date of filing: **29.10.82**

(54) Analog to digital converter.

(30) Priority: **30.10.81 JP 174167/81**

(43) Date of publication of application:
**11.05.83 Bulletin 83/19**

(45) Publication of the grant of the patent:
**14.10.87 Bulletin 87/42**

(84) Designated Contracting States:
**AT DE FR GB NL**

(56) References cited:
**DE-A-2 419 642**
**FR-A-2 298 906**
**FR-A-2 330 208**
**GB-A-1 504 528**
**US-A-4 008 468**
**US-A-4 122 439**

(73) Proprietor: **SONY CORPORATION**
**7-35 Kitashinagawa 6-Chome Shinagawa-ku**
**Tokyo 141 (JP)**

(72) Inventor: **Wakita, Toshiaki**
**c/o Sony Corporation 7-35 Kitashinagawa 6-chome**
**Shinagawa-ku, Tokyo (JP)**

(74) Representative: **Ayers, Martyn Lewis Stanley et al**
**J.A. KEMP & CO. 14 South Square Gray's Inn**
**London, WC1R 5EU (GB)**

Courier Press, Leamington Spa, England.

## Description

The present invention relates generally to an analog to digital converter.

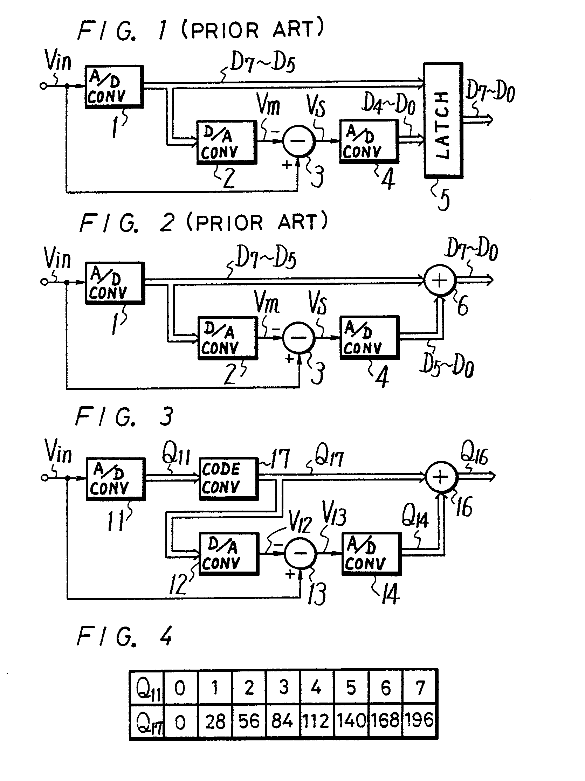

In the prior art, when for example, a luminance signal of a video signal is subjected to analog to digital conversion, an analog to digital (hereinafter referred simply to as A/D) converter of serial to parallel type such as that shown in Figure 1 of the accompanying drawings may be employed.

The prior art A/D converter shown in Figure 1 is used to carry out 8-bit A/D conversion. In this case, an analog input voltage $V_{in}$ is applied to an A/D converter 1 of, for example, 3-bits from which digital outputs $D_7$ to $D_5$ constituting the upper 3 bits of the resulting digital word are obtained. These 3-bit digital output $D_7$ to $D_5$ are supplied to a digital to analog (hereinbelow referred simply to as D/A) converter 2 and then converted thereby to an analog voltage $V_m$. This voltage $V_m$ and the input voltage $V_{in}$ are both applied to a subtracting circuit 3 from which a difference voltage $V_s=V_{in}-V_m$ is derived. This difference voltage $V_s$ is applied to a 5 bit A/D converter 4 from which digital outputs $D_4$ to $D_0$ constituting the lower 5 bits of the digital word are derived. The digital outputs $D_7$ to $D_5$ and those $D_4$ to $D_0$ are delivered through a latch 5 as an A/D converted output of 8 bits.

With the above serial to parallel type A/D converter, even when the input voltage $V_{in}$ is converted to a digital output of $(m+n)$ bits, it is enough that the number of voltage comparing circuits required in the A/D converters 1 and 4 is $2^m+2^n-2$. Therefore, when the A/D converter is formed as an integrated circuit, its chip size can be reduced and its power consumption can be also reduced.

With this serial to parallel type A/D converter, however, the upper bit converter 1 needs to have an accuracy the same as that of the lower bit converter 4. The reason is as follows.

When the digital values $D_7$ to $D_0$ are increased by "1" from "31", by way of example, the value "32" is presented. In other words, then "00011111" is changed to "00100000", the lower bits $D_4$ to $D_0$ are changed from "11111" to "00000", while the upper bits $D_7$ to $D_5$ are changed from "000" to "001". Accordingly, in the case of the converter shown in Figure 1, when the input voltage $V_{in}$ is increased from "31" to "32", the outputs $D_7$ to $D_5$ from the converter 1 must be increased by "1" from "000" to "001". On the other hand when the input voltage $V_{in}$ is changed from the value "28" to "29", if the outputs $D_7$ to $D_5$ from the converter 1 are increased from "000" to "001", this is erroneous. This is the same not only for the case that the input voltage $V_{in}$ is increased from the value "31" to "32" but also when the input voltage $V_{in}$ is increased from "63" to "64" or more generally that a change in the bits $D_4$ to $D_0$ causes a carry to bits $D_7$ to $D_5$. Further, the same applies where the input voltage $V_{in}$ is decreased and the bits $D_7$ to $D_5$ are shifted to the bits $D_4$ to $D_0$. Accordingly, even though the converter 1 is a 3 bit A/D converter, it requires 5 bit accuracy the same as the converter 4.

If the converter does not have this accuracy due to the above-mentioned error, the ouputs $D_7$ to $D_0$ do not change monotonically at the junction between $D_7$ to $D_5$ and $D_4$ to $D_0$.

To avoid the above defect, a converter such as that shown in Figure 2 is known which compensates for the accuracy of the converter 1. In this example, the converter 4 is provided with a redundant bit so as to be 6-bits, and 6-bit outputs $D_5$ to $D_0$ therefrom and the outputs $D_7$ to $D_5$ from the converter 1 are added in an adding circuit 6 so as to make the $D_5$ bits coincident with each other.

Using the converter shown in Figure 2, even if the converter 1 is relatively poor in accuracy, the correct digital outputs $D_7$ to $D_0$ can be obtained from the adding circuit 6.

In the converter shown in Figure 2, however, since the redundant bit is added, the A/D conversion of, say, 9 bits (512 steps) is inherently possible but only 8 bit (256 steps) A/D conversion is actually performed; namely a half of it is useless.

US—A—4122439 and GB—A—1504528 disclose analog to digital converters according to the precharacterising part of claim 1.

According to the present invention there is provided an analog to digital converter comprising: a first analog to digital converter for converting a first analog signal to a first digital signal; a code converter for converting said first digital signal to a second digital signal; a digital to analog converter for converting said second digital signal to a second analog signal; a subtractor for subtracting said second analog signal from said first analog signal; a second analog to digital converter for converting an output signal of said subtractor to a third digital signal; and an adder for adding said second digital signal and said third digital signal, characterised in that the total number of output bits from the adder being taken as k, the number of bits which are converted by said first analog to digital converter being m, said code converter multiplies said first digital signal by T, the following relation holding among the constants

$$2^{k-1}<T\times 2^m<2^k$$ and the number of bits in the second digital signal is greater than the number of bits in the first digital signal.

The above and other features and advantages of the present invention will become apparent from the following description, given by way of non-limiting example, taken in conjunction with the accompanying drawings throughout in which like reference numerals designate the same elements and parts.

Figures 1 and 2 are respectively block diagrams showing prior art A/D converters;

Figure 3 is a block diagram showing an example of the A/D converter according to the present invention;

Figure 4 is a tabulation for illustrating the relation between a signal $Q_{11}$ and a signal $Q_{17}$; and

Figure 5 is a graph showing the relation between an input signal $V_{in}$ and an output signal $Q_{14}$.

An embodiment of the present invention will be described below with reference to the drawings which is free from the defects of the prior art serial to parallel type A/D converter.

An example of the A/D converter according to the invention will be now described with reference to Figure 3.

In the example of the invention shown in Figure 3, the analog input voltage $V_{in}$ is applied to an A/D converter 11 of, for example, 3-bits to be thereby converted to a digital value $Q_{11}$ of 3-bits. In this case, the conversion accuracy (scattering upon conversion) of the converter 11 is within $+2$ LSB (least significant bit) of the final digital outputs $D_7$ to $D_0$ and the value "28" of the lower 5 bits $D_4$ to $D_0$ is taken as to correspond to "1" of the signal $Q_{11}$.

The signal $Q_{11}$ is supplied to a code-converter 17 formed of, for example, a ROM (read only memory) and then converted to a digital value $Q_{17}$ (which is 8 bits) 28 times the value $Q_{11}$ as shown in Figure 4. This signal $Q_{17}$ is supplied to a D/A converter 12 and then converted to an analog voltage V12. This voltage V12 is applied to a substracting circuit 13 which is also supplied with the input voltage $V_{in}$ so that the subtracting circuit 13 produces a difference voltage $V_{13}=V_{in}-V_{12}$.

The voltage $V_{13}$ is applied to an A/D converter 14 of, for example, 5-bits and converted to a digital value $Q_{14}$ of 5-bits. This signal $Q_{14}$ is supplied to an adding circuit 16 to which the signal $Q_{17}$ from the converter 17 is also supplied so that the adding circuit 16 produces an added signal $Q_{16}=Q_{14}+Q_{17}$.

With the A/D converter of the invention constructed as described above, the output signal Q16 is as follows:

$$Q_{16}=Q_{14}+Q_{17}$$
$$=V_{13}+Q_{17}$$
$$=(V_{in}-V_{12})+Q_{17}$$
$$=V_{in}-Q_{17}+Q_{17}$$
$$=Vin$$

Thus, this signal $Q_{16}$ is the A/D converted output of the input voltage $V_{in}$.

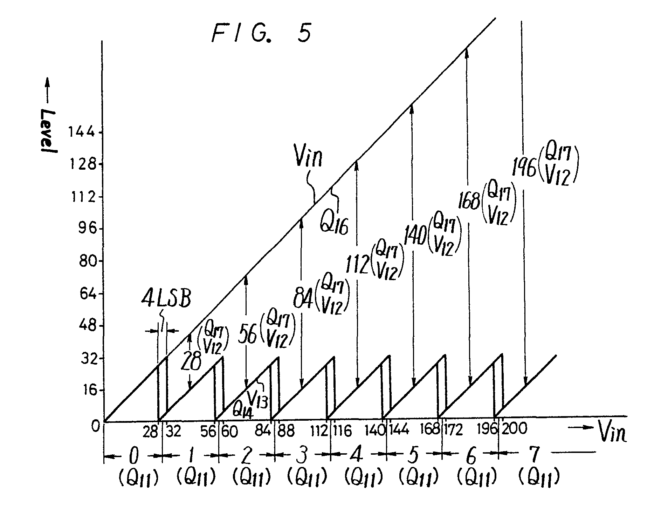

Now, the above relation will be explained with reference to the graph of Figure 5. As shown in Figure 5, the output signal $Q_{11}$ from the A/D converter 11 always includes the scattering of $\pm 2$ LSB so that for the signal $Q_{11}$ to be shifted to the preceding or succeeding value completely, a width of 4 LSB is required. If the input voltage $V_{in}$ exists within this width or an interval of 4 LSB, it is uncertain whether the value of the signal $Q_{11}$ becomes the preceding or succeeding value.

Further, since the output signal $Q_{17}$ from the converter 17 is such that it is provided by merely code-converting the signal $Q_{11}$, the signal $Q_{17}$ also includes a similar uncertainty width for the input voltage $V_{in}$ and further the voltage $V_{12}$ provided by A/D converting the signal $Q_{17}$ is similar to the former. Accordingly, the difference voltage $V_{13}=V_{in}-V_{12}$ from the subtracting circuit 13 varies in sawtooth form with the input voltage $V_{in}$ and also includes uncertainty widths of 4 LSB at its step-difference portions.

Since the signal Q14 provided by A/D converting the voltage $V_{13}$ is added to the signal $Q_{17}$ as the output signal $Q_{16}$, the uncertainties of 4 LSB width are cancelled in the signal $Q_{16}$ and hence this signal comprises no error.

As described above, according to the present invention, even if any error exists in the A/D converter 11 for the upper bits, the output signal is not affected thereby. Further, the redundant bit required in the prior art A/D converter shown in Figure 2 is unnecessary in the A/D converter of this invention, so that the A/D converter has excellent efficiency.

In the above example of this invention, assuming that the number of bits in the first analog to digital converter (11) is m, which is selected to be 3 in this embodiment, and the number of bits in the second analog to digital converter (14) is n, which is selected to be 5 in this embodiment, the dynamic range becomes as follows;

$$\{2^n-(2+2)\}\times 2^m+2+2=28\times 8+2+2=228 \text{ (steps)}$$

under the condition that there is existing an uncertainty of width $\pm 2$ LSB at the step-difference portions.

It should be noted that

$$2^n-(2+2)=28$$

is equivalent to the multiplication factor of code converter (17). In other words, if the multiplication factor of the code converter (17) is expressed as T, T is given by subtracting the width of the 4 LSB uncertanty from the total number of steps 32 in the second analog to digital converter. From the above reason, the value of T is not arbitrary, but must be determined on basis of the number of bits in the first and second analog to digital converters and the uncertainty widths of the first analog to digital converter. This means that if the product T is selected

$$2^{m+n-1}<T\times 2^m<2^{m+n}$$

it will be possible to operate the present analog to digital converter effeciently and exactly. Thus, the dynamic range of the converter becomes narrower than the maximum of 256 steps for 8—bits. However, when, for example, the luminance signal is A/D converted, a further narrower dynamic range is enough. Thus, the above 228 steps are sufficient. If, however, 256 steps are required, it is sufficient that an A/D converter having an over-range output is used as the A/D converter 11.

In the above example of the invention, the input voltage $V_{in}$ is converted into the digital signal $Q_{16}$ of "0" to "227", but using the relation $Q_{17}=Q_{11}\times 8+16$ the signal $Q_{16}$ becomes "16" to

"243" and hence the redundancy can be distributed at the upper and lower sides of the signal $Q_{16}$.

The above description is given on a preferred embodiment of the invention, but it will be apparent that many modifications and variations could be effected by one skilled in the art without departing from the scope of the invention, as defined in the appended claims.

## Claims

1. An analog to digital converter comprising: a first analog to digital converter (11) for converting a first analog signal ($V_{in}$) to a first digital signal (Q11); a code converter (17) for converting said first digital signal (Q11) to a second digital signal (Q17); a digital to analog converter (12) for converting said second digital signal (Q17) to a second analog signal (V12); a subtractor (13) for subtracting said second analog signal (V12) from said first analog signal ($V_{in}$); a second analog to digital converter (14) for converting an output signal of said subtractor (13) to a third digital signal (Q14); and an adder (16) for adding said second digital signal and said third digital signal, characterised in that the total number of output bits from the adder (16) being taken as k, the number of bits which are converted by said first analog to digital converter (11) being m, said code converter (17) multiplies said first digital signal (Q11) by T, the following relation holding among the constants

$$2^{k-1} < T \times 2^m < 2^k$$

and the number of bits in the second digital signal is greater than the number of bits in the first digital signal.

2. An analog to digital converter as claimed in claim 1 wherein said code converter is formed of a ROM.

## Patentansprüche

1. Analog-Digital-Wandler mit einem ersten Analog-Digital-Wandler (11) zur Umwandlung eines ersten Analogsignals ($V_{in}$) in ein erstes Digitalsignal ($Q_{11}$),

mit einem Kodewandler (17) zur Umwandlung des ersten Digitalsignals ($Q_{11}$) in ein zweites Digitalsignal ($Q_{17}$),

mit einem Digital-Analog-Wandler (12) zur Umwandlung des zweiten Digitalsignals ($Q_{17}$) in ein zweites Analogsignal ($V_{12}$),

mit einem Subtrahierer (13) zum Subtrahieren des zweiten Analogsignals ($V_{12}$) von dem ersten Analogsignal ($V_{in}$),

mit einem zweiten Analog-Digital-Wandler (14) zur Umwandlung des Ausgangssignals des Subtrahierers (13) in ein drittes Digitalsignal ($Q_{14}$),

und mit einem Addierer (16) zum Addieren des zweiten Digitalsignals und des dritten Digitalsignals,

dadurch gekennzeichnet,

daß unter der Annahme, daß Gesamtzahl von Ausgangsbits des Addierers (16) gleich k, die Zahl der Bits, die in dem ersten Analog-Digital-Wandler (11) umgewandelt werden, gleich m ist und der Kodewandler (17) das erste Digitalsignal ($Q_{11}$) mit T multipliziert, folgende Beziehung zwischen den Konstanten gilt

$$2^{k-1} < T \cdot 2^m < 2^k$$

und die Zahl der Bits in dem zweiten Digitalsignal größer ist als die Zahl der Bits in dem ersten Digitalsignal.

2. Analog-Digital-Wandler nach Anspruch 1 bei dem der Kodewandler von einem ROM gebildet ist.

## Revendications

1. Convertisseur analogique-numérique comportant: un premier convertisseur analogique-numérique (11) destiné à convertir un premier signal analogique ($V_{in}$) en un premier signal numérique (Q11); un convertisseur de code (17) destiné à convertir ledit premier signal numérique (Q11) en un second signal numérique (Q17); un convertisseur numérique-analogigue (12) destiné à convertir ledit second signal numérique (Q17) en un second signal analogique (V12); un soustracteur (13) destiné à soustraire ledit second signal analogique (V12) dudit premier signal analogique ($V_{in}$); un second convertisseur analogique-numérique (14) destiné à convertir un signal de sortie dudit soustracteur (13) en un troisième signal numérique (Q14); et un additionneur (16) destiné à additionner ledit second signal numérique et ledit troisième signal numérique, caractérisé en ce que, le nombre total des bits de sortie de l'additionneur (16) étant pris comme k, le nombre des bits qui sont convertis par ledit premier convertisseur analogique-numérique (11) étant m, ledit convertisseur de code (17) multiplie ledit premier signal numérique (Q11) par T, la relation ci-après étant respectée parmi les constantes:

$$2^{k-1} < T \times 2^m < 2^k$$

et le nombre des bits dans le second signal numérique est supérieur au nombre des bits dans le premier signal numerique.

2. Convertisseur analogique-numérique selon la revendication 1, dans lequel ledit convertisseur de code est constitué par une ROM.

0 078 687

FIG. 1 (PRIOR ART)

FIG. 2 (PRIOR ART)

FIG. 3

FIG. 4

| $Q_{11}$ | 0 | 1 | 2 | 3 | 4 | 5 | 6 | 7 |
|---|---|---|---|---|---|---|---|---|
| $Q_{17}$ | 0 | 28 | 56 | 84 | 112 | 140 | 168 | 196 |

1

FIG. 5

0 078 687

2